(19) Europäisches Patentamt

European Patent Office

Office européen des brevets

(11) EP 1 088 394 B1

## (12) EUROPEAN PATENT SPECIFICATION

(45) Date of publication and mention
of the grant of the patent:
**14.01.2004 Bulletin 2004/03**

(51) Int Cl.7: **H03H 21/00**

(86) International application number:
**PCT/US1999/013550**

(21) Application number: **99928697.4**

(22) Date of filing: **16.06.1999**

(87) International publication number:
**WO 1999/066638 (23.12.1999 Gazette 1999/51)**

(54) **ADAPTIVE STATE SPACE SIGNAL SEPARATION, DISCRIMINATION AND RECOVERY ARCHITECTURES AND THEIR ADAPTATIONS FOR USE IN DYNAMIC ENVIRONMENTS**

ADAPTIVE ZUSTANDSRAUM-SIGNALTRENNUNG, UNTERSCHEIDUNGS- UND RÜCKGEWINNUNGSARCHITEKTUREN UND IHRE ANPASSUNGEN ZUR VERWENDUNG IN DYNAMISCHEN UMGEBUNGEN

ARCHITECTURES DE SEPARATION, DE DISCRIMINATION ET DE RECUPERATION ADAPTATIVES DE SIGNAUX DANS L'ESPACE DES ETATS ET LEURS ADAPTATIONS POUR UTILISATION DANS DES ENVIRONNEMENTS DYNAMIQUES

(84) Designated Contracting States:
**AT BE CH CY DE DK ES FI FR GB GR IE IT LI LU MC NL PT SE**

(30) Priority: **18.06.1998 US 89750 P**

(43) Date of publication of application:
**04.04.2001 Bulletin 2001/14**

(73) Proprietor: **Clarity, LLC**
**Troy, MI 48084 (US)**

(72) Inventors:
 • **ERTEN, Gamze**
  **Okemos, MI 48864 (US)**
 • **SALAM, Fathi, M.**
  **Okemos, MI 48864 (US)**

(74) Representative: **Haines, Miles John**
**D. Young & Co.**
**21 New Fetter Lane**
**London EC4A 1DA (GB)**

(56) References cited:
 **WO-A-98/58450          US-A- 5 383 164**

 • **HOANG-LAN NGUYEN THI ET AL: "BLIND SOURCE SEPARATION FOR CONVOLUTIVE MIXTURES" SIGNAL PROCESSING EUROPEAN JOURNAL DEVOTED TO THE METHODS AND APPLICATIONS OF SIGNAL PROCESSING, vol. 45, no. 2, 1 August 1995 (1995-08-01), pages 209-229, XP000556279 ISSN: 0165-1684**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

# EP 1 088 394 B1

**Description**

<u>BACKGROUND OF THE INVENTION</u>

<u>Field of the Invention</u>

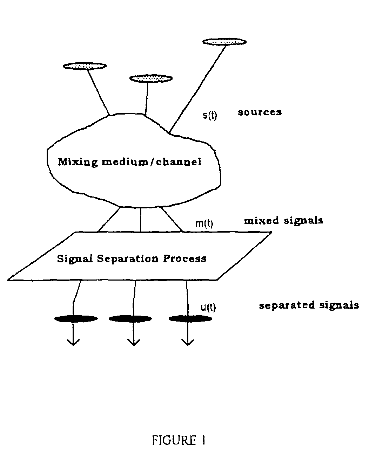

This invention pertains to systems for recovering original signal information or content by processing multiple measurements of a set of mixed signals. More specifically the invention pertains to adaptive systems for recovering several original signals from received measurements of their mixtures. To best understand the problem solved by the invention, and previous approaches to solve this problem, the following problem statement is helpful: With reference to FIGURE 1 of the attached drawings, consider N independent signals $s_1(t)$, ..., and $s_N(i)$. These signals may represent any of, or a combination of, independent speakers or speeches, sounds, music, radio-based or light based wireless transmissions, electronic or optic communication signals, still images, videos, etc. These signals may be delayed and superimposed with one another by means of natural or synthetic mixing in the medium or environment through which they propagate. One consequently desires an architecture, framework, or device that, upon receiving the delayed and superimposed signals, works to successfully separate the *independent* signal sources using a set of appropriate algorithms and procedures for their applications.

<u>Discussion of Related Art</u>

The recovery and separation of independent sources is a classic but difficult signal processing problem. The problem is complicated by the fact that in many practical situations, many relevant characteristics of both the signal sources and the mixing media are unknown.

Two main categories of methods are used:

1. Neurally inspired adaptive algorithms (e.g.. U.S. Patent Nos. 5,383,164 and 5,315,532), and
2. Conventional discrete signal processing (e.g., U.S. Patent Nos. 5,208,786 and 5,539,832).

<u>Neurally inspired adaptive arhitectures and algorithms</u> follow a method originally proposed by J. Herault and C. Jutten. now called the Herault-Jutten (or HJ) algorithm. The suitability of this set of methods for CMOS integration have been recognized. However, the standard HJ algorithm is at best heuristic with suggested adaptation laws that have been shown to work mainly in special circumstances. The theory and analysis of prior work pertaining to the HJ algorithm are still not sufficient to support or guarantee the success encountered in experimental simulations. Herault and Jutten recognize these analytical deficiencies and they describe additional problems to be solved. Their proposed algorithm assumes a linear medium and filtering or no delays. Specifically, the original signals are assumed to be transferred by the medium via a matrix of unknown but constant coefficients. To summarize. the Herault-Jutten method (i) is restricted to the full rank and linear static mixing environments, (ii) requires matrix inversion operations. and (iii) does not take into account the presence of signal delays. In many practical applications, however. Uttering and relative delays do occur. Accordingly, previous work fails to successfully separate signals in many practical situations and real world applications.

<u>Conventional signal processing</u> approaches to signal separation originate mostly in the discrete domain in the spirit of traditional digital signal processing methods and use the statistical properties of signals. Such signal separation methods employ computations that involve mostly discrete signal transforms and filter/transform function inversion. Statistical properties of the signals in the form of a set of cumulants are used to achieve separation of mixed signals where these cumulants are mathematically forced to approach zero. This constitutes the crux of the family of algorithms that search for the parameters of transfer functions that recover and separate the signals from one another. Calculating all possible cumulants, on the other hand, would be impractical and too time consuming for real time implementation.

The specifics of these methods are elaborated in these categories below.

1. Neurally Inspired Architectures and Algorithms for Signal Separation

These set of neurally inspired adaptive approaches to signal separation assume that the "statistically independent" signal vector $S(t) = [s_1(t) ,..., \text{and } s_N(t)]^T$ is mixed to produce the signal vector M(t). The vector M(t) is received by the sensors (e.g. microphones, antenna. etc.).

Let the mixing environment be represented by the general (static or dynamic) operator $\mathfrak{I}$ . Then,

$$M(t) = \Im(S(t)) \qquad\qquad \text{Equation (1)}$$

There are several formulations that can be used to invert the mixing process. i.e., operator $\Im$ in a "blind" fashion where no apriori knowledge exists as to the nature or content of the mixing operator $\Im$ or the original sources S(t). We group these into two categories, static and dynamic. Additional distinctions can be made as to the nature of the employed adaptation criteria, e.g., information maximization, minimization of high order cumulants, etc.

1.1. The Static Case

The static case is limited to mixing by a constant nonsingular matrix. Let us assume that the "statistically independent" signal vector S(t) = $[s_1(t) , ..., \text{and } s_N(t)]^T$ is mixed to produce the signal vector M(t). Specifically, let the mixing operator $\Im$ be represented by a constant matrix A, namely

$$M(t) = A\, S(t) \qquad\qquad \text{Equation (2)}$$

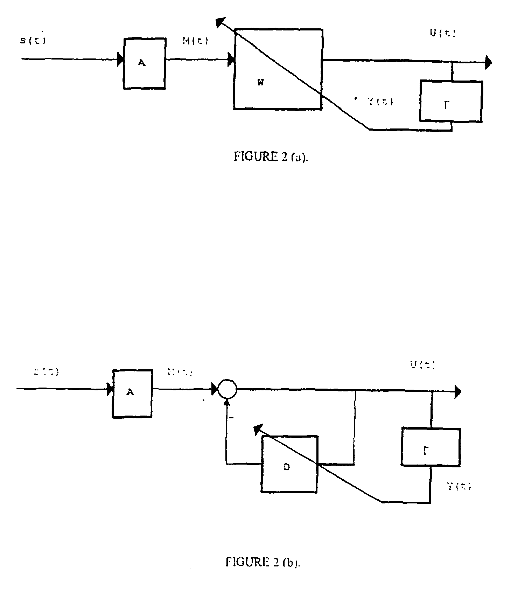

In FIGURE 2, two architectures that outline the modeling of the mixing and the separation environments and processes are shown. The architecture in FIGURE 2(a) necessarily computes the inverse of the constant mixing matrix A, which requires that A is invertible, i.e., $A^{-1}$ exists.

The alternate architecture in FIGURE 2(b) does not impose this restriction in that upon convergence the off diagonal elements of the matrix D are exactly those of the off diagonal elements of the matrix A. In this case, however. diagonal elements of the matrix A are restricted to equal "1.0." By setting the diagonal elements of D to zero, one essentially concludes that the mixing process is invertible even if the mixing matrix is not.

In both cases. S(t) is the set of unknown sources, M(t) is the set of mixtures. U(t) is the set of separated signals that estimate S(t), and Y(t) is the set of control signals used to update the parameters of the unmixing process. As shown in FIGURE 2, the weight update utilizes a function of the output U(t).

In the First case, we labeled the unmixing matrix W, and in the second case we labeled it D. Note that D has zero diagonal entries. The update of the entries of these two matrices is defined by the criteria used for signal separation, discrimination or recovery. e.g., information maximization, minimization of higher order cumulants, etc.

As an example, one possible weight update rule for the case where

$$U(t) = W\, M(t) \qquad\qquad \text{Equation (3)}$$

could be

$$w_{ij} = \eta[W^{-T} + g''(u)/g'(u)M^{T}]_{ij} \qquad\qquad \text{Equation (4)}$$

where $\eta$ is sufficiently small, g is an odd function, and M is the set of mixtures, U is the set of outputs which estimate the source signals, superscript T denotes transpose, and -T denotes inverse of transpose. Note that the function g ( ) plays an additional role in the update which can be related to the above diagram as

$$Y(t) = g(U(t)) \qquad\qquad \text{Equation (5)}$$

One uses Equation (4) to update the entries of W in Equation (3). Through this is an iterative update procedure, the entries of W converge so that the product WA is nearly equal to the identity matrix or a permutation of the identity matrix.

On the other hand, in the second case, one potentially useful rule for the update of the D matrix entries $d_{ij}$ is generically described as

$$d_{ij} = \eta\, f(u_i(t))g(u_j(t)) \qquad\qquad \text{Equation (6)}$$

where $\eta$ is sufficiently small. In practice some useful functions for f (.) include a cubic function, and for g (.) include a hyperbolic tangent function. When using this procedure, one computationally solves for U(t) from Equation (7) below

$$U(t) = [I + D]^{-1} M(t) \qquad \text{Equation (7)}$$

at each successive step and sample point. This computation is a potentially heavy burden, especially for high dimensional D.

1.2. The Dynamic Case

The dynamic mixing model accounts for more realistic mixing environments, defines such environment models and develops an update law to recover the original signals within this framework.

In the dynamic case, the matrix A is no longer a constant matrix. In reference to the feedback structure of the static example, it is simpler to view Equation (7) where $U(t) = [I + D]^{-1} M(t)$ as an equation of the fast dynamic equation

$$\tau\, U(t) = - U(t) - D\, U(t) + M(t) \qquad \text{Equation (8)}$$

This facilitates the computation by initializing the differential equation in Equation (8) from an arbitrary guess. It is important however to ensure the separation of time scales between Equations (8) and the update procedure like the one defined by Equation (6). This may be ensured by making $\eta$ in Equation (6) and $\tau$ in Equation (8) sufficiently small.

If we assume the dimensionality of M(t) is N, a set of differential equations that define the dynamic signal separation algorithm can be written as

$$\tau_i \dot{u}_i = -u_i - \sum_{i \neq i} D_{i} u_i + m_i$$

$$\text{for } i = 1 \ldots\ldots N \qquad \text{Equation (9)}$$

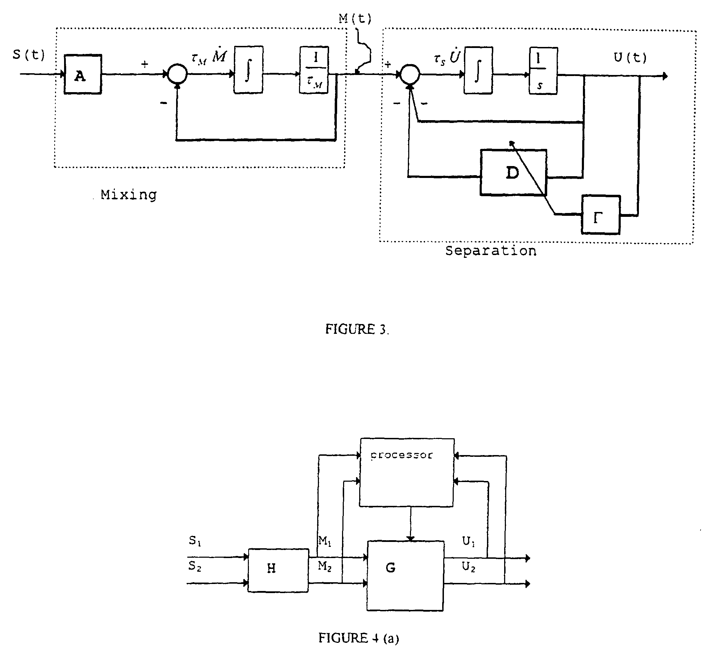

This enumerates N differential equations. In addition, the adaptation process for the entries of the matrix D can be defined by multiple criteria, e.g., the evaluation of functions f ( ) and g ( ) in Equation (6). FIGURE 3 is a pictorial illustration of the dynamic model in feedback configuration.

Current methods outline little in the way of procedures for the application of adaptation criteria within the architectures defined thus far. Two implied procedures have been noted:

First is the application of the signal separation functions, adaptation procedures and criteria to arbitrary points of data - regardless of whether each of these points is practically and physically accessible or not. Thus. the adaptive separation procedure applies the adaptation functions and criteria to each element of the measured mixed signals individually and instantaneously, after which appropriate parameter updates are made.

The second type of procedure has been described in FIGURE 2(a) that uses Equation (3). In this case, the criteria is applied to the entire data set, or selected data points from the entire data set. Thus, the related adaptation process does not progress per sample, but utilizes the whole data set over which a constant, static mixing matrix is assumed to apply. Although this method is somewhat more robust than the first, it is essentially an off-line method not suitable for real time signal separation. Furthermore, when the assumption of a static constant matrix is incorrect. the accuracy of the unmixing process suffers.

1.3. Feedforward State Space

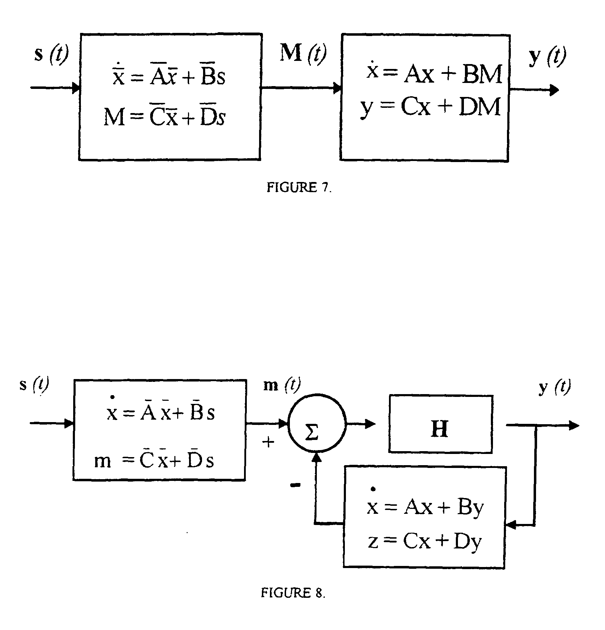

The architecture is shown in FIGURE 7. Let the n-dimensional source signal vector be s, and the m-dimensional measurement vector be M. The mixing environment may be described by the Linear Time-Invariant (LTI) state space:

$$\dot{\overline{X}} = \overline{A}\,\overline{X} + \overline{B}\,s$$
$$M = \overline{C}\,\overline{X} + \overline{D}\,s$$

Equation (10)

The parameter matrices $\overline{A}$, $\overline{B}$, $\overline{C}$ and $\overline{D}$ are of compatible dimensions. This formulation encompasses both continuous-time and discrete-time dynamics The dot on the state $\overline{X}$ means derivative for continuous-time dynamics, it however means "advance" for discrete-time dynamics. The mixing environment is assumed to be (asymptotically) stable, i.e., the matrix $\overline{A}$ has its eigenvalues in the left half complex plane. The (adaptive) network is proposed to be of the form

$$\dot{X} = A\,X + B\,M$$
$$y = C\,X + D\,M.$$

Equation (11)

where y is the n-dimensional output, X is the internal state, and the parameter matrices are of compatible dimensions. For simplicity, assume that X has the same dimensions as $\overline{X}$. FIGURE (7) depicts the feed forward form of this framework.

The first question is the following: Does there exist parameter matrices A, B, C. and D which would recover the original signals? The answer now follows.

Existence of solutions to the recovery problem:

We state that the (adaptive) dynamic network would be able to counter act the mixing environment, if the network parameters are set at (or attain via an adaptive scheme) the following values:

$$A = A^* = T(\overline{A} - \overline{B}[D]\overline{C})T^{-1}$$

Equation (12)

$$B = B^* = T\,\overline{B}\,[D]$$

Equation (13)

$$C = C^* = -[D]\,\overline{C}\,T^{-1}$$

Equation (14)

$$D = D^* = [D]$$

Equation (15)

where [D] equals
$D^{-1}$ : the inverse of D, if m=n,
$(\overline{D}^T\overline{D})^{-1}\,D^{-T}$; a pseudo-inverse, if m>n, and
$D^{-T}\,(\overline{D}\overline{D}^T)^{-1}$: a pseudo-inverse if m < n.
The matrices A*, B*, and C* can take on a family of values due to the *nonsingular* state-equivalent transformation T. We shall use T to render the network architecture "canonical" or simple from a realization view point. This formulation in effect generalizes the formulations in the literature, which are limited to FIR filters, predominantly for 2-dimensional sources and two measurements, into general n-dimensional sources, and m-dimensional measurements. Note that, this modeling includes the FIR filtering models, and extends to IIR filtering if A is nonzero.

While this feedforward form for the adaptive network is viable, we note a limitation for its applicability. namely, that the parameters of the mixing environment have to be such that the matrix A* is (asymptotically) stable. That is, for a stable mixing environment, the composite matrix of the adaptive network

$$A^* = \overline{A} - \overline{B}[D]\overline{C}$$

Equation (16)

must be (asymptotically) stable, i.e., has its eigenvalues in the left half complex plane. It is apparent that this requirement places a limiting condition on the allowable mixing environments which may exclude certain class of applications!

2. The Transfer Function Based Approach to Signal Separation

The representation of signal mixing and separation by transfer functions makes this approach a dynamic environment model and method.

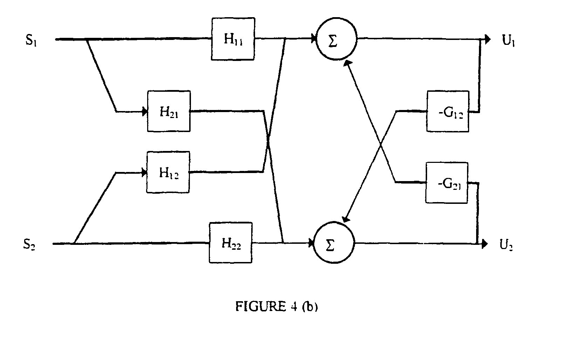

Current methods thus define a structure for separating two signals by processing two mixture measurements, which was illustrated in FIGURE 4.

Other architectures for the separation functions in the transfer function domain results in three serious shortfalls which are all impediments to the design and implementation of a practical method and apparatus. First, this formulation, as expressed, precludes the generalization of the separation procedure to higher dimensions. where the dimensionality of the problem exceeds two. In other words, a practical formalization of the separation method does not exist when there are more than two mixtures and two sources. One can illustrate this by direct reference to other approaches, where matrix multiplication terms are written out, so that each scalar equation defines one of the entries of the resulting product matrix desired to be equal to zero. Since permutations of a diagonal matrix are also allowed, multiple sets of equations are created. For a two mixture problem, this results in two pairs (four total) of equations, each with two product terms. Beyond that the number of equations increases. To be precise the number of equations needed to describe the number of equations for a specific permutation of the N dimensional case is equal to $(N^2-N)$. For the two dimensional problem this value is 2.

Second, the inversion procedure for the transfer function is ad hoc and no recipe or teaching exists. The impact of dimensionality plays a crucial role in this. It is apparent from the method that the resuming architecture gives rise to networks requiring transfer components whose order is dependent on products of the transfer components of the mixing environment. Thus, one can not design a network architecture with a fixed order.

Third, the initial conditions can not be defined since the formulation is not in the time domain and can not be initialized with arbitrary initial conditions. Hence. the method is not suitable for real time or on line signal separation.

WO98/58450 (having a priority date before but is published after the priority date of the present application and thus represents state of the art according to Article 54(3) EPC) discloses methods and apparatus for blind signal separation which enables separation and recovery of several unknown mixed signals with little assumption of the original signals. This is achieved by processing the signals, or functions thereof, according to multiple criteria.

In particular this document does not disclose the implementation of a signal separation architecture comprising a feedback state space representation, as defined in Claims 1 and 19.

An example of blind signal separation is shown in Hoang-Lan Nguyen Thi, et al: "Blind source separation for convolutive mixtures", Signal Processing European Journal, vol. 45, no. 2, 1 August 1995, pages 209-229, Amsterdam, NL. This document discloses adaptive algorithms for the separation of wide-band signals and for convolutive mixtures modelled by finite impulse response (FIR) filters. The algorithms estimate the coefficients of FIR filters using an independence criteria.

### SUMMARY OF INVENTION

A first aspect of the present invention is directed to an acoustic signal discrimination system for discriminating a plurality of input signals $M$ into a plurality of output signals $Y$, the input signals being composed of functions of a plurality of source signals that have been affected by a medium, the source signals being associated with a plurality of sources, the output signals estimating the source signals, the system comprising an architecture processor for defining and computing a plurality of parameters of a signal separation architecture, the architecture comprising a feedback state space representation establishing a relationship between the input signals and the output signals as

$$\dot{X}_i = A_i X_i + B_i Y \text{ for } 1 \leq i \leq L$$

$$Z = \sum_{i=1}^{L} C_i X_i + DY$$

$$Y = M - Z$$

where $X_i$ represents a state vector of the environment, $L$ is the number of state vectors, $A_i$, $B_i$, $C_i$ and $D$ are parameter matrices describing the enviroment, whereby $A_i$ and $B_i$ are state update matrices, and $C_i$ and $D$ are matrices updated according to

$$\dot{C}_i = \gamma C_i \left(- I + f_a(Y) X^T\right)$$

$$\dot{D} = \eta D \left(- I + f_a(Y) Y^T\right)$$

where $I$ is a performance index, $\gamma$ and $\eta$ are constants, $f_a(\bullet)$ is a non-linear odd function, and superscript T denotes the transpose.

A second aspect of the present invention is directed to a method for separating a plurality of source signals comprising:

receiving a plurality of input signals $M$;
computing a plurality of output signals $Y$, the output signals estimating the source signals, the output signals based on parameters of a signal separation architecture; and
presenting the plurality of output signals;

wherein the signal separation architecture comprises a feedback state space representation establishing a relationship between the input signals and the output signals as

$$X_i = A_i X_i + B_i Y \text{ for } 1 \leq i \leq L$$

$$Z = \sum_{i=1}^{L} C_i X_i + DY$$

$$Y = M - Z$$

where $X_i$ represents a state vector of the environment, $L$ is the number of state vectors, $A_i$, $B_i$, $C_i$ and $D$ are parameter matrices describing the enviroment, whereby $A_i$ and $B_i$ are state update matrices, and $C_i$ and $D$ are matrices updated according to

$$\dot{C}_i = \gamma C_i \left(- I + f_a(Y) X^T\right)$$

$$\dot{D} = \eta D \left(- I + f_a(Y) Y^T\right)$$

where $I$ is a performance index, $\gamma$ and $\eta$ are constants, $f_a(\bullet)$ is a non-linear odd function, and superscript T denotes the transpose.

BRIEF DESCRIPTION OF THE DRAWINGS

FIGURE 1. Signal separation, discrimination and recovery problem statement.
FIGURE 2. Architecture of the signal separation and recovery network in case of static mixing by matrix A. U(t) is the output which approximates the original source signals s(t). Y(t) contain the values that are used in updating the parameters of the unmixing processes, i.e., W in (a) and D in (b).
FIGURE 2(a). A static neural network structure for signal separation. U(t) approximates S(t). Y(t) is used for weight update of the network.
FIGURE 2(b) An alternate static neural network structure for signal separation. U(t) approximates S(t). Y(t) is used for weight update of the feedback network.
FIGURE 3. Architecture of the signal separation and recovery network in case of feedback dynamic mixing and separation models. U(t) approximates S(t). The function g defines the criteria used for weight update of the feedback network.

FIGURE 4. (a) Conventional transfer function representation for signal mixing and separation for a two signal system. The two signals $U_1$ and $U_2$ approximate S1 and S2. G inverts the mixing process modeled as H. (b) The method is described only in two dimensions. The computation procedure and is neither practical nor extendible in the case of higher dimensional signals. Furthermore, the extension of the mixing environment to transfer function domain has also eliminated the time domain nature of the signals. This also causes the exclusion of the initial conditions from the set of equations.

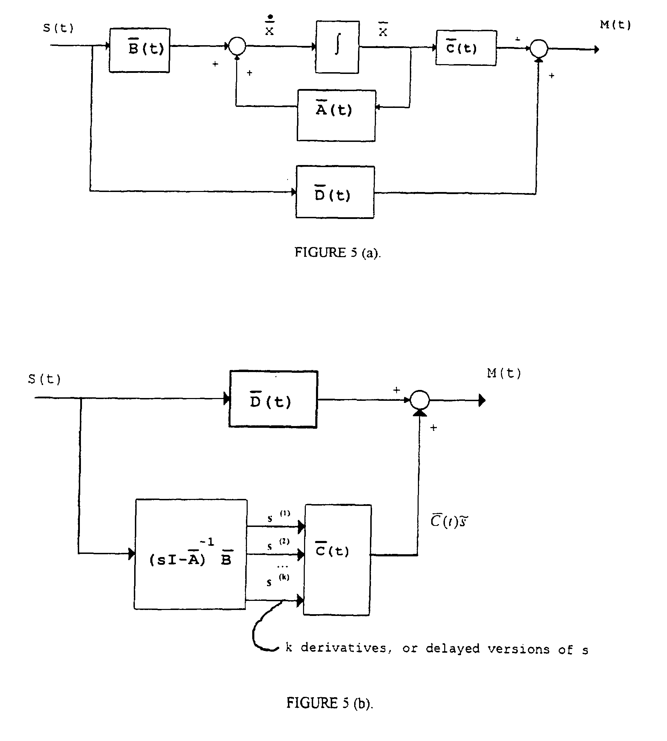

FIGURE 5. Two mixing models for the state space time domain architecture. (a) General framework. (b) Special case where $\bar{A}$ and $\bar{B}$ are fixed, and its relation to conventional signal processing. Both models apply to multiple types of separation architectures.

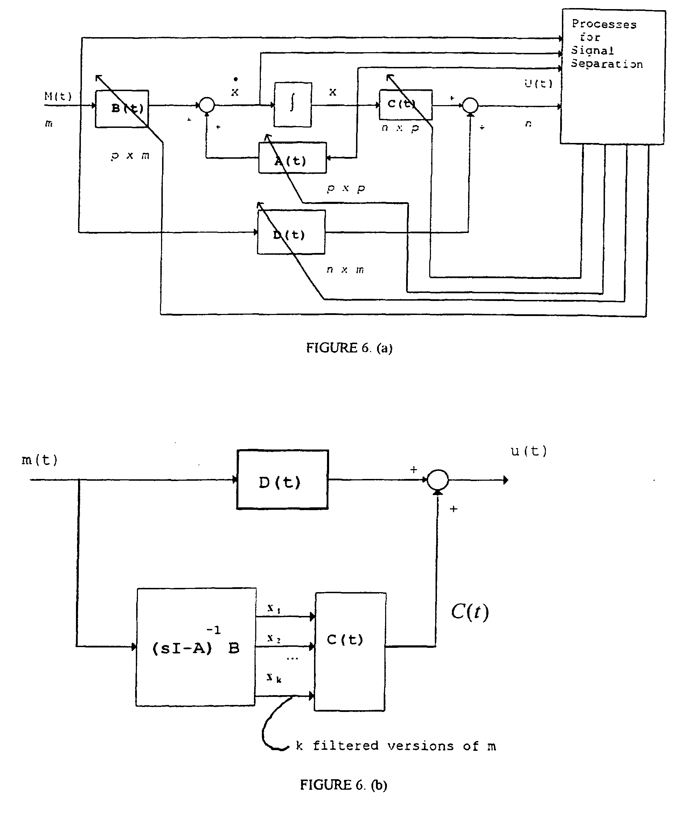

FIGURE 6. Signal separation model for the state space time domain architecture, (a) General model and architecture, (b) Special case, only the model is shown without the arrows in (a) which depict parameter update procedures.

FIGURE 7. Feedforward state space architecture.

FIGURE 8. Feedback state space architecture according to the invention.

FIGURE 9. (a) Flowchart of the method of the present invention. (b) DSP implementation architecture. A/D stands for analog to digital conversion, and D/A for digital to analog conversion. The internals of the DSP may include a variety of functional units as shown below. Different configurations are possible depending on the nature of the application, number of mixtures, desired accuracy, etc.

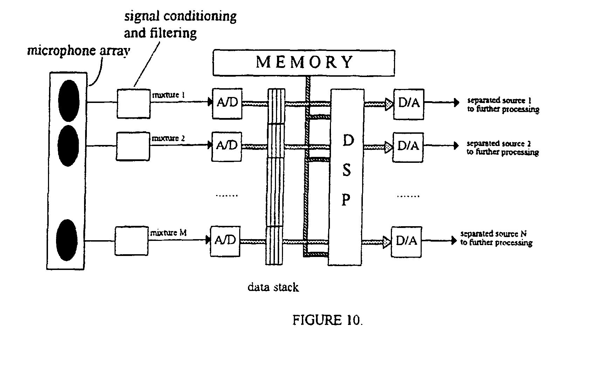

FIGURE 10. Audio application based on the signal separation and recovery procedures of this invention. Audio signals are converted electrical signals by the elements of the microphone array. Each element of the microphone array receives a different version (or mixture) of the sounds in the environment. Different arrangements of microphone elements can be designed depending on the nature of the application. number of mixtures, desired accuracy, and other relevant criteria. Following some signal conditioning and filtering, these mixture signals are converted from analog format to digital format, so that they can be stored and processed. The digital signal processor of the system is programmed in accordance with the procedures for signal separation and recovery procedures of this invention. The internals of the DSP may include a variety of functional units for various arithmetic and logic operations, and digital representation, data storage and retrieval means to achieve optimum performance. Circuits and structures shown in figure may undergo further integration towards realization of the whole system on a single chip.

## DETAILED DESCRIPTION OF THE INVENTION

The present invention seeks to recover and separate mixed signals transmitted through various media wherein the separation of signals is of such high quality as to substantially increase (i) the signal carrying capacity of the medium or channel, (ii) the quality of the received signal, or (iii) both. The media or channels may include a combination of wires, cables, fiber optics, wireless radio or light based frequencies or bands, as well as a combination of solid, liquid, gas particles, or vacuum.

The present invention also seeks to separate mixed signals through media or channel wherein a high quality of signal separation is achieved by hardware currently available or produceable by state of the art techniques.

The system of this invention introduces a set of generalized frameworks superior to the described preexisting approaches for coping with a range of circumstances unaddressed to date. Specifically, the feedback state space architecture shown in FIGURE 8 and its continuous and discrete renditions are described. Moreover, the architecture is mapped onto a set of adaptive filters in both FIR and IIR form, commonly used by those skilled in the art of digital signal processing. In addition, many functions and procedures for the adaptive computation of parameters pertinent to the architectures of this invention are outlined. Both the architectures and the procedures for adaptive computation of parameters are designed for achieving on-line real time signal separation, discrimination and recovery. The most practically pertinent shortfalls of many other techniques, namely the failure to account for multiple or unknown number of signals in the mixing, noise generation, changing mixing conditions, varying signal strength and quality, and some nonlinear phenomena are addressed by the formulations of this invention. The invented method overcomes the deficiencies of other methods by extending the formulation of the problem to include two new sets of architectures and frameworks, as well as a variety of parameter adaptation criteria and procedures designed for separating and recovering signals from mixtures.

Introduction

This invention presents a framework that addresses the blind signal separation and recovery (or de-convolution) in dynamic environments. The original work was motivated by the work of Herault and Jutten and Comon. Most of the recent results have focused primary on establishing analytical foundation of the results reported by Herault, Jutten and Kullback. Several researchers have used a host of analytical tools that include applied mathematics, statistical signal processing, system theory, dynamical systems and neural networks. The challenge still exists in generalizing the environment to more general dynamic systems.

Several theoretical results and formulations address the blind separation and recovery of signals in dynamic environments. We consider state space dynamic models to represent the mixing environment and consequently the adaptive network used to perform the signal separation and recovery. We employ dynamic models which are easily, and directly, adapted to discrete as well as continuous time channels. The presented environment model and the adaptive network allow for the case when the mixing environment includes (state) feedback and memory. The feedback of the state/output corresponds to Infinite Impulse Response (IIR) filtering in the discrete-time case, where as the feedforward corresponds to the FIR formulation.

The emphasis of our method is in developing the network architecture, and the improved convergent algorithms, with a view towards efficient implementations. An improved approximation of the (nonlinear) mutual information/ entropy function is used in order to ensure whitening and also to eliminate the assumption of output unit covariance. The improved expansion produces an odd polynomial in the network outputs which includes a linear term, as well as higher order terms -- all absent from the expansion in other methods. It should be noted however, that some work has addressed only the static case where the mixing environment is represented by a constant matrix. Specifically, a formulation for an FIR filter was also converted into a static matrix mixing problem.

Method Summary

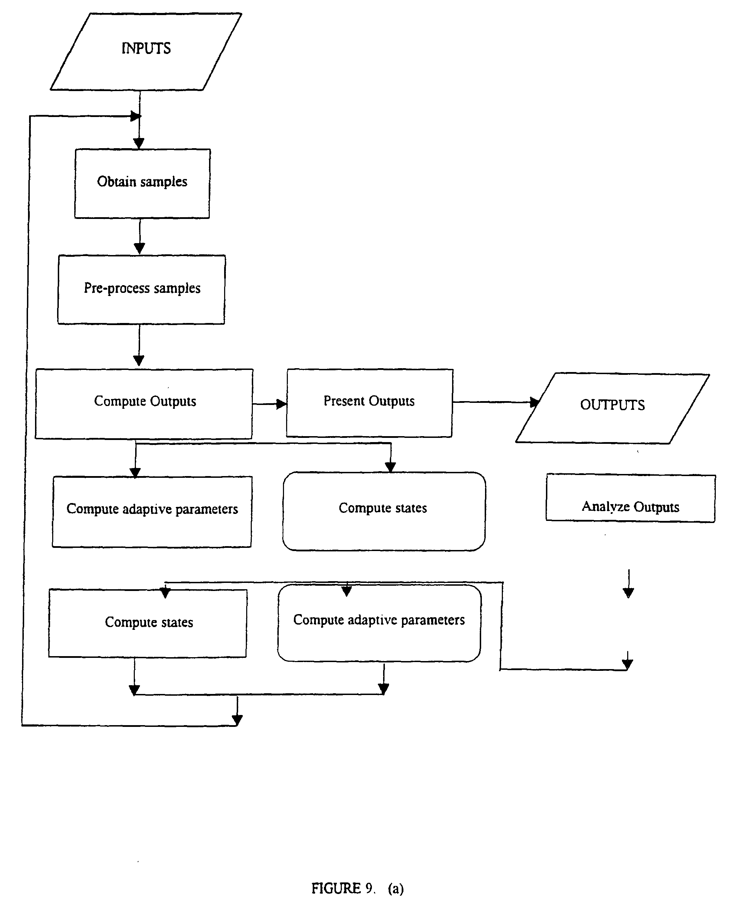

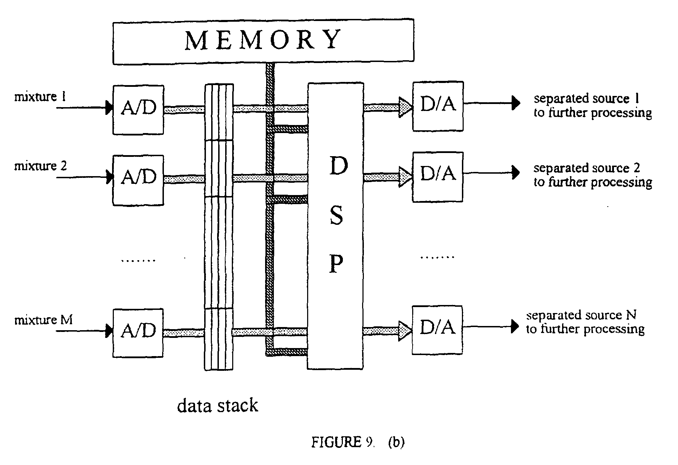

FIGURE 9(a) shows a process flow diagram of a method of the present invention. This includes (1) obtaining samples, (2) pre-processing of the samples, (3) computing outputs using the present value of the states or adaptive parameters, (4) computing adaptive parameters, (5) computing internal states, and storing and/or presenting of outputs.

Obtaining samples includes obtaining the multi channel data recorded through multiple sensors, e.g., microphones. Such data could also come from previously recorded outputs of said multiple sensors or mixtures thereof, e. g., mixed tracks of sounds. Data can be sampled on line for a real time or near real time process, or be recalled from a storage or recording media. e.g., tape, hard disk drive, etc.

Preprocessing of the samples include various processing techniques for manipulation of the obtained samples, including but not limited to up or down sampling to vary the effective sampling rate of data, application of various frequency filters, e.g., low, high, or band pass filters, or notch filters, linear or nonlinear operations between sensor outputs of the present or previous samples, e.g., weighted sum of two or more sensors. buffering, random, pseudorandom or deterministic selection and buffering, windowing of sampled data or functions of sampled data, and various linear and nonlinear transforms of the sampled data.

Computing outputs uses the states and parameters computed earlier. It is also possible delay this step until after the computation of adaptive parameters, or after the computation of the internal states, or both. Moreover, alternately, outputs could be computed twice per sample set.

Computing of adaptive parameters may involve a method or multiple methods which use the derivatives of a function to compute the value of the function, the function defining the constraints imposed on the adaptive parameters. One or more such constraints can be used. A variety of methods and criteria specifically for computation of adaptive parameters are outlined in the present invention.

Computing of internal states involves invoking the structure of the architecture, along with the current or available values of adaptive parameters. The internal states may be in the form of a vector of states, scalar states, their samples in time, or their derivatives. The particular architecture defines the number of states.

Dynamic Architectures

Dynamic models encompass and describe more realistic environments. Both feedforward and feedback architectures of the state space approach can be implemented. Feedforward linear state space architecture was listed above. Throughout this description, we shall refer to the mathematical model for signal mixing as the *mixing environment,* while we refer to the mathematical model for the signal recovery as *the (adaptive) network.*

The method of this invention extends the environment to include more realistic models beyond a constant matrix, and develops successful update laws. A crucial first step is to include dynamic linear systems of the *state space* which are more general than FIR filters and transfer functions due to the inclusion of feedback and variations in initial conditions. Moreover, these models lend themselves to direct extension to nonlinear models. Another motivation of this work is to enable eventual implementation in analog or mixed mode microelectronics.

The formulation addresses the feedback *dynamic* structures, where the environment is represented by a suitable realization of a dynamic linear system.

The Feedforward Linear Structure:

The feedforward state space architecture was described in the introduction section and illustrated in FIGURE 7.

The Feedback Linear Structures:

A more effective architecture than its feedforward precursor is the so-called (output) feedback network architecture, see FIGURE 8. This architecture leads to less restrictive conditions on the network parameters. Also, because of feedback, it inherits several known attractive properties of feedback systems including, robustness to errors and disturbances, stability, and increased bandwidth. These gains will become apparent from the following equations

Existence of solutions to the recovery problem

If y is to converge to a solution proportional (via a permutation matrix P) to s, namely, y= Ps, then, the following parameter matrices of the (adaptive) network will constitute a solution that recovers the original signals:

$$A = A^* = T \bar{A} T^{-1}$$

$$B = B^* = T \bar{B} P^{-1}$$

$$C = C^* = \bar{C} T^{-1}$$

$$D = D^* = \bar{D} P^{-1} - H$$

In addition to the expected desired properties of having feedback in the architecture of the network, we also achieve simplicity of solutions to the separation/recovery of signals. In this case, the architecture is not introducing additional constraints on the network. Note that H in the forward path of the network may in general represent a matrix in the simplest case, or a transfer function of a dynamic model. Furthermore, in the event that m=n, H may be chosen to be the identity matrix.

The elements of the procedure and its advantages are now apparent. Further generalizations of the procedures for developing the architectures can also account for non-minimum phase mixing environments. These steps are straightforward application of the above procedure and hence will not be elaborated upon.

An important generalization is to include nonlinearity as part of the architecture-- explicitly. One model is to include nonlinearity as a static mapping of the measurement variable M(t). In this event, the adaptive network needs to include a compensating nonlinearity at its input stage. Thus, the input must include an "inverse-type" nonlinearity to counter act the measurement prior to further processing. This type of mixing environment is encountered in wireless applications that include satellite platforms.

The dynamic architecture defined in this proper way ensures that a solution to the blind signal separation does exist. We now move to the next step of defining the proper adaptive procedure/algorithm which would enable the network to converge to one of its possible solutions. Consequently, after convergence, the network will retain the variable for signal processing/recovery.

Discrete State Space Representation and Specialization to Discrete-time IIR and FIR Filters

Performance Measure/Functional

The mutual information of a random vector y is a measure of dependence among its components and is defined as follows:

In the continuous case:

$$L(y) = \int_{y \in Y} p_y(y) \ln \left| \frac{p_y(y)}{\prod_{j=1}^{j=r} p_{y_j}(y_j)} \right| dy$$

In the discrete case:

$$L(y) = \sum_{y \in Y} p_y(y) \ln \left| \frac{p_y(y)}{\prod_{j=1}^{j=r} p_{y_j}(y_j)} \right|$$

An approximation of the discrete case:

$$L(y) \cong \sum_{k=k_0}^{k_1} p_y(y(k)) \ln \left| \frac{p_y(y(k))}{\prod_{j=1}^{j=r} p_{y_j}(y_j(k))} \right|$$

where $p_y(y)$ is the probability density function (pdf) of the random vector **y**, whereas $p_{y_i}(y_i)$ is the probabilty density of the j-th component of the output vector **y**. The functional *L*(*y*) is always non-negative and is zero if and only if the components of the random vector **y** are statistically independent. This important measure defines the *degree of dependence* among the components of the signal vector. Therefore, it represents an appropriate functional for characterizing (the degree of) statistical independence. *L*(**y**) can be expressed in terms of the entropy

$$L(\mathbf{y}) = -H(\mathbf{y}) + \sum_i H(y_i)$$

where H(**y**):= - E[ln$f_y$], is the **entropy** of **y**, and E[.] denotes the expected value.

The General Nonlinear Discrete Time Non-Stationary Dynamic Case:

The Environment Model

Let the environment be modeled as the following nonlinear discrete-time dynamic (forward) processing model:

$$X_p(k+1) = f_p^k(X_p(k), s(k), w_1^*)$$

$$m(k) = g_p^k(X_p(k), s(k), w_2^*)$$

where s(k) is an n-dimensional vector of original sources. m(k) is the m-dimensional vector of measurements, $X_p(k)$ is the $N_p$-dimensional state vector. The vector (or matrix) $w_1^*$ represents constant/parameter of the dynamic equation, and $w_2^*$ represents constant/parameter of the "output" equation. The functions $f_p(.)$ and $g_p(.)$ are differentiabie. It is also assumed that existence and uniqueness of solutions of the differential equation are satisfied for each set of initial conditions $X_p(t_0)$ and a given waveform vector s(k).

<u>The Processing Networks</u>

The (processing) network may be represented by a dynamic (forward) network or a dynamic feedback network.
The Feedfonvard Network is

$$X(k+1) = f^k(X(k),m(k),w1)$$

$$y(k) = g^k(X(k),m(k),w2)$$

where k is the index, m(k) is the m-dimensional measurement, y(k) is the r-dimensional output vector. $X(k)$ is the N-dimensional state vector. (Note that N and $N_p$ may be different.) The vector (or matrix) $w_1$ represents the parameter of the dynamic equation, and $w_2$ represents the parameter of the "output" equation. The functions $f(.)$ and $g(.)$ are differentiable. It is also assumed that existence and uniqueness of solutions of the differential equation are satisfied for each set of initial conditions $X(t_0)$ and a given measurement waveform vector m(k).

<u>Update Law for the discrete-time dynamic network: general nonlinear case</u>

The update law is now developed for dynamic environments to recover the original signals. The environment here is modeled as a linear dynamical system. Consequently, the network will also be modeled as a linear dynamical system.
The network is a feedforward dynamical system. In this case, one defines the performance index

$$J_0(w_1, w_2) = \sum_{k=k_0}^{k_1-1} L^k(y_k)$$

subject to the discrete-time nonlinear dynamic network

$$X_{k+1} = f^k(X_k,m_k,w_1), \qquad X_{k_0}$$

$$y_k = g^k(X_k,m_k,w_2)$$

It noted that this form of a general nonlinear time varying discrete dynamic model includes both the special architectures of multilayered recurrent and feedforward neural networks with any size and any number of layers. It is more compact, mathematically. to discuss this general case but its direct and straightforward specialization to feedforward and recurrent (feedback) models is strongly noted.
Then, the augmented cost function to be optimized becomes

$$J_0'(w_1, w_2) = \sum_{k=k_0}^{k_1-1} L^k(y_k) + \lambda_{k-1}^T(f^k(X_k,m_k,w_1) - X_{k+1})$$

The Hamiltonian is then defined as

$$H^k = L^k(y(k)) + \lambda_{k-1}^T f^k(X,m,w_1)$$

Consequently, the sufficient conditions for optimality are:

$$X_{k+1} = \frac{\partial H^k}{\partial \lambda_{k+1}} = f^k(X_k, m_k, w_1)$$

$$\lambda_k = \frac{\partial H^k}{\partial X_k} = (f^k_{X_k})^T \lambda_{k+1} + \frac{\partial L^k}{\partial X_k}$$

$$\Delta w_1 = -\eta \frac{\partial H^k}{\partial w_1} = -\eta (f^k_{w_1})^T \lambda_{k+1}$$

$$\Delta w_2 = -\eta \frac{\partial H^k}{\partial w_2} = -\eta \frac{\partial L^k}{\partial w_2}$$

The boundary conditions arc as follows: the first equation, the state equation, uses an initial condition, while the second equation, the co-state equation, uses a final condition equal to zero. The parameter equations use initial values with small norm which may be chosen randomly or from a given set.

General Discrete Linear Dynamic Case:

Environment

$$\bar{X}_p(k+1) = \bar{A}\, \bar{X}_p(k) + \bar{B}\, s(k)$$

$$m(k) = \bar{C}\, \bar{X}_p(k) + \bar{D}\, s(k)$$

Feedforward Network

$$X(k+1) = A\, X(k) + B\, m(k)$$

$$y(k) = C\, X(k) + D\, m(k)$$

The first question is the following: Does there exist parameter matrices of the processing network which would recover the original signals? The answer is yes, the explicit solutions of the parameters are given next.

Existence of solution to the recovery problem:

The Update law for the linear dynamic case

$$X_{k+1} = \frac{\partial H^k}{\partial \lambda_{k+1}} = f^k(X, m, w_1) = AX_k + Bm_k$$

$$\lambda_1 = \frac{\partial H^k}{\partial X_k} = (f^k_{X_k})^T \lambda_{k+1} + \frac{\partial L^k}{\partial X_k} = A^T_k \lambda_k + C^T_k \frac{\partial L^k}{\partial y_k}$$

$$\Delta A = -\eta \frac{\partial H^k}{\partial A} = -\eta (f_A^k)^T \lambda_{k+1} = -\lambda_{k+1} X_k^T$$

$$\Delta B = -\eta \frac{\partial H^k}{\partial B} = -\eta (f_B^k)^T \lambda_{k-1} = -\lambda_{k+1} m_k^T$$

$$\Delta D = -\eta \frac{\partial H^k}{\partial D} = -\eta \frac{\partial L^k}{\partial D} = \eta ([D]^{-T} - f_a(y) m^T)$$

$$\Delta C = -\eta \frac{\partial H^k}{\partial C} = -\eta \frac{\partial L^k}{\partial C} = \eta (-f_a(y) X^T)$$

Specialization to IIR and FIR Filters

The general discrete-time linear dynamics of the network are given as:

$$X(k+1) = A\, X(k) + B\, m(k)$$

$$y(k) = C\, X(k) + D\, m(k)$$

where m(k) is the m-dimensional vector of measurements, y(k) is the n-dimensional vector of (processed) outputs, and X(k) is the (mL) dimensional states (representing filtered versions of the measurements in this case). One may view the state vector as composed of he L m-dimensional state vectors $X_1, X_2, ..., X_L$. That is,

$$X_k = X(k) = \begin{bmatrix} X_1(k) \\ X_2(k) \\ ... \\ X_L(k) \end{bmatrix}$$

Special Case:

Consider the case where the matrices and A and B are in the "controllable canonical form." We represent the A and B block matrices as,

$$A = \begin{bmatrix} A_{11} & A_{12} & ... & A_{1L} \\ I & 0 & ... & 0 \\ ... & I & ... & 0 \\ 0 & 0 & I & 0 \end{bmatrix}. \quad \text{and} \quad B = \begin{bmatrix} I \\ 0 \\ ... \\ 0 \end{bmatrix}$$

where each block sub-matrix $A_{lj}$ may be simplified to a diagonal matrix, and each I is a block identity matrix with appropriate dimensions.
Then,

$$X_1(k+1) = \sum_{i=1}^{L} A_{1i} X_i(k) + m(k)$$

$$X_2(k+1) = X_1(k)$$

$$\dots$$

$$X_L(k+1) = X_{L-1}(k)$$

$$y(k) = \sum_{i=1}^{L} C_i X_i(k) + D m(k)$$

This model represents an IIR filtering structure of the measurement vector m(k). In the event that the block matrices $A_1$, are zero. then the model is reduced to the special case of an FIR filter.

$$X_1(k+1) = m(k)$$

$$X_2(k+1) = X_1(k)$$

$$\dots$$

$$X_L(k+1) = X_{L-1}(k)$$

$$y(k) = \sum_{j=1}^{L} C_j X_j(k) + D m(k)$$

The equations may be re-wrmen in the well-known FIR form

$$X_1(k) = m(k-1)$$

$$X_2(k) = X_1(k-1) = m(k-2)$$

$$\dots$$

$$X_L(k) = X_{L-1}(k-1) = m(k-L)$$

$$y(k) = \sum_{j=1}^{L} C_j X_j(k) + D m(k)$$

This last equation relates the measured signal *m(k)* and its delayed versions represented by $X_j(k)$, to the output *y(k)*.

Special Canonical Representation cases:

The matrices *A* and *B* are best represented in the "controllable canonical forms" or the form I format. That B is constant and A has only the first block rows as parameters in the IIR network case. In that event, No update equation for the matrix B are used. While for the matrix A only the first block rows are updated. Thus the update law for the matrix A is limited to

$$\Delta A_{1j} = -\eta \frac{\partial H^k}{\partial A_{1j}} = -\eta (f_{A_{1j}}^k)^T \lambda_{k+1} = -\eta \lambda_1(k+1) \, X_j^T \, (k)$$

Noting the form of the matrix A, the co-state equations can be expanded as

$$\lambda_1(k) = \lambda_2(k+1) + C_1^T \frac{\partial L^k}{\partial y_k}(k)$$

$$\lambda_2(k) = \lambda_1(k+1) + C_2^T \frac{\partial L^k}{\partial y_k}(k)$$

$$\vdots$$

$$\lambda_L(k) = C_L^T \frac{\partial L^k}{\partial y_k}(k)$$

$$\lambda_1(k+1) = \sum_{l=1}^{L} C_l^T \frac{\partial L^k}{\partial y_k}(k+l)$$

Therefore, the update lam for the block sub-matrices in A are:

$$\Delta A_{1j} = -\eta \frac{\partial H^k}{\partial A_{1j}} = -\eta \lambda_1(k+1) X_j^T(k) = -\eta \sum_{l=1}^{L} C_l^T \frac{\partial L^k}{\partial y_k}(k+l) \, X_j^T$$

The $[D]^{-T}$ represents the transpose of the pseudo-inverse of the D matrix. The update laws for the matrices D and C can be elaborated upon as follows:

$$\Delta D = \eta([D]^{-T} - f_a(y)m^T) = \eta(I - f_a(y)(Dm)^T)[D]^{-T}$$

where I is a matrix composed of the r x r identity matrix augmented by additional zero row (if n > r) or additional zero columns (if n < r). In light of considering the "natural gradient," an alternate update law in this case is

$$\Delta D = \eta([D]^{-T} - f_a(y)m^T)D^T D = \eta(I - f_a(y)(Dm)^T)D$$

For the C matrix, the update equations can be written for each block matrix as follows:

$$\Delta C_j = -\eta \frac{\partial H^k}{\partial C_j} = -\eta \frac{\partial L^k}{\partial C_j} = \eta(-f_a(y) X_j^T)$$

If one reduces the state space by eliminating the internal state, one reduces the system to a static environment where

$$m(t) = \bar{D} S(t)$$

In discrete notation it is defined by

$$m(k) = \bar{D}S(k)$$

Two types of (discrete) networks have been described for separation of statically mixed signals. These are the feed forward network where the separated signals y(k) are

$$y(k) = WM(k)$$

and feedback network where y(k) is defined as

$$y(k) = m(k) - Dy(k)$$

$$y(k) = (I + D)^{-1} m(k)$$

Discrete update laws suggested for these are as follows
In case of the feedforward network,

$$W^{l+1} = W^l + \mu \left\{ -f(y(k)) \quad g^T(y(k)) + \propto I \right\}$$

and in case of the feedback network.

$$D^{l+1} = D^l + \mu \left\{ f(y(k))g^T(y(k)) - \propto I \right\}$$

where ($\propto$I) may be replaced by time windowed averages of the diagonals of the $f(y(k))$ $g^T(y(k))$ matrix.
Note: One may also use multiplicative weights in the update. The following "dynamic" FIR models can demonstrate analogous update law modifications.

Environment Model:

In an FIR, single delay case, the mixed samples m(k) are defined by the equation

$$m(k) = \bar{D}_0 S(k) + D_1 S(k-1) = \sum_{i=0}^{1} \bar{D}_i S(k-i)$$

Separating feedforward network Model

This network produces approximated source signals y(k) defined by

$$y(k) = \sum_{j=1}^{L} W_j M(k-j)$$

Using the update laws for matrices $W_0$ to $W_L$ as follows:

$$\Delta W_0 = \mu_0 \left\{ \propto I - f(y(k)) \, g(y(k))^T \right\}$$

$$\Delta W_1 = -\mu_1 \{f(y))g(y(k-1)\}^T$$

or $\quad \Delta W_1 = -\mu_{12} \left\{ f(y(k))g(y(k-1))^T + \gamma f(y(k-1))g(y(k)^T \right\}$

. . . . . . . . . . . . .

$$\Delta W_L = -\mu_L \left\{ f(y(k)) \left[ \sum_{\ell=1}^{L} g(y(k-\ell)^T) \right] \right\}$$

or $\quad \Delta W_L = -\mu_L \left\{ f(y(k)) \left[ \sum_{\ell=1}^{L} g(y(k-\ell))^T \right] + \gamma \left[ \sum_{\ell=1}^{L} f(y(k-\ell)) \right] g(y(k)^T \right\}$

A specific update can be performed simply by means of adding the rate of change $\Delta W$ to $W$ as

$$W^{t+1} = W^t + \Delta W$$

or by another known integration method for computing values of variables from their derivatives.

Continuous Time Models

This invention introduces a set of update laws and links minimization of mutual information and the information maximization of the output entropy function of a nonlinear neural network, specifically in relation to techniques for blind separation, discrimination and recovery of mixed signals. The system of the invention enables the adaptive blind separation and recovery of several unknown signals mixed together in changing interference environments with very minimal assumption on the original signals.

In the previous section. discrete time models were developed. This section deals primarily with continuous time derivations. These continuous system derivations parallel those in the discrete case and described here to complement the continuous time models. It is noted that continuous time and discrete time derivations in the content of this invention for the large part are analogous of each other. Updates laws of one domain can also be converted to update laws of the other domain by those skilled in the art.

Performance Measure/Functional

The mutual information of a random vector y is a measure of dependence among its components and is defined as follows:

In the continuous case:

$$L(y) = \int_{y \in \mathcal{Y}} p_y(y) \ln \left| \frac{p_y(y)}{\prod_{j=1}^{L} p_{y_j}(y_j)} \right| dy$$

In the discrete case:

$$L(y) = \sum_{y \in y} p_y(y) \ln \left| \frac{p_y(y)}{\prod_{j=1}^{j=r} p_y(y_j)} \right|$$

An approximation of the discrete case:

$$L(y) \cong \sum_{k=k_0}^{k_1} p_y(y(k)) \ln \left| \frac{p_y(y(k))}{\prod_{j=1}^{j=r} p_y(y_j(k))} \right|$$

where $p_y(y)$ is the probability density function (pdf) of the random vector **y**, whereas $p_{y_j}(y_j)$ is the probabilty density of the j-th component of the output vector **y**. The functional **L(y)** is always non-negative and is zero if and only if the components of the random vector y are statistically independent. This important measure defines the *degree of dependence* among the components of the signal vector. Therefore. it represents an appropriate functional for characterizing (the degree of) statistical independence. *L(y)* can be expressed in terms of the entropy

$$L(\mathbf{y}) = -H(\mathbf{y}) + \sum_i H(y_i)$$

where H(**y**) := - E[ln$f_y$], is the **entropy** of **y**, and E[.] denotes the expected value.

Derivation of the Update Law

Assume a linear feedforward structure of the neural network as shown below.

Then the probability density functions fo the (random vector) output and the mixed input variables are related asThe mutual information of a random vector **y** is a measure of independence among its components and can be defined as:

$$f_y(u) = \frac{f_m(u)}{|W|}.$$

Thus,

$$L(\mathbf{y}) = -H(\mathbf{y}) + \sum_i H(y_i)$$

can be written as

$$L(\mathbf{y}) = -H(M) - \ln|W| + \sum_i H(y_i)$$

To optimize (actually. minimize) L(y) as a function of W, knowledge (or approximation) of only the marginal entropies is required. Such information is not available, by hypothesis, and thus one needs to approximate these quantities in order to minimize L(y). Comon and Amari et. al. used respectively an Edgeworth and a Charlier-Gram expansion of the pdf's to approximate the marginal entropies. The approximation produces:

$$L(y):= \varnothing(M,y,W)$$

the derivations lead to the following gradient update rule

$$\dot{W} = \eta[W^T - f_a(y)M^T]$$

where functional approximation leads to a different function $f_a(y)$. Our work assumed a Charlier-Gram expansion and includes higher approximations than used previously. In our case, the function $f_a(y)$ is given by

$$f_a(y) = \frac{71}{12} y^{15} - \frac{355}{12} y^{13} + \frac{190}{3} y^{11} - \frac{4033}{24} y^9 + \frac{941}{3} y^7 + \frac{47}{8} y^5 + y^3 + y$$

As an example, the algorithm defined by the previous two equations converges when a uniform random noise and sine function are applied as unknown sources. One can use the natural gradient to express the update law defined previously as $\dot{W} = \eta[W^{-T} - f_a(y)M^T]$ as

$$\dot{W} = \eta[L - f_a(y)y^T]W$$

In this case, simulations show that such an algorithm converges for a variety of signals. However, it falls if a random and a sine waveforms were used. These results will also apply if some nonlinear functions are used. Hence, in this case, both functions have similar effects.

Parameter Update Techniques for Continuous Dynamic Environments

We consider more realistic environments, define their models and apply the update law to recover the original signals. In our formulation, the environment is modeled as linear dynamic system. Consequently, the network will also be modeled as a linear dynamic system.

The update law is now developed for dynamic environments to recover the original signals. The environment here is modeled as a linear dynamical system. Consequently, the network will also be modeled as a linear dynamical system.

The Feedforward Case:

The network is a feedforward dynamical system as in FIGURE 7. In this case, one defines the performance index

$$J(\mathbf{x}, \mathbf{w}) = \int_0^T \mathcal{L}(t, \mathbf{x}, \dot{\mathbf{x}}, \lambda, \mathbf{w}) dt$$

where $\mathcal{L}$ is the Lagrangian and is defined as

$$\mathcal{L}(t, \mathbf{x}, \dot{\mathbf{x}}, \lambda, \mathbf{w}) = \phi(t, \mathbf{x}, w) + \lambda^T(\dot{\mathbf{x}} - A\mathbf{x} - B\mathbf{e})$$

where $\lambda(t)$ is the adjoint state equation defined by

$$\dot{\lambda} = -A^T\lambda + \frac{\partial\phi}{\partial\mathbf{x}}$$

The functional $\phi$ may represent a scaled version of our measure of dependence I (y), **w** is a vector constructed of the rows of the parameter matrices C and D. Note that a canonical realization may be used so that B is constant. The matrix A, in the canonical representation, may have only N-parameters, where N is the dimension of the state vector X. The parameters, A, C, and D, represented generically by $\mathbf{w}p$, will be updated using the general gradient descent form:

$$\dot{\mathbf{w}}p = -\eta\frac{\partial\mathcal{L}}{\partial\mathbf{w}p}$$

Therefore, using the performance index defined as

$$I(\mathbf{y}) = -H(\mathbf{y}) + \sum_i H(y_i),$$

the matrices C and D are updated according to

$$\dot{D} = \eta(I - f_a(y)y^T)D$$

$$\dot{C} = \gamma(I - f_a(y)x^T)C$$

where $f_a(.)$ is given by a variety of nonlinear *expansive* odd-functions which include hyperbolic sine, and the inverse of a sigmiodal function.

In one specific computation/approximation, the function is given as

$$f_a(y) = \frac{71}{12}y^{15} - \frac{355}{12}y^{13} + \frac{190}{3}y^{11} - \frac{4033}{24}y^9 + \frac{941}{3}y^7 + \frac{47}{8}y^5 + y^3 + y$$

The essential features in using the above equation for $f_a(y)$ are summarized as follows:

    1. it is analytically derived and justified.
    2. it includes a linear term in y and thus enables the performance of second order statistics necessary for signal whitening,
    3. it contains higher order terms which emanate from the 4th order cumulant statistics in the output signal y, and
    4. it does not make the assumption that the output signal has unity covariance.

The function for $f_a(y)$ represents the only function used in the literature to date with the above characteristics.

This function, therefore, exceeds the limitations of the other analytically derived functions.

Computer simulations confirm that the algorithm converges if the function for $f_a(y)$ defined above is used.

The Feeback Architecture

The (output) feedback architecture of FIGURE 8 may be simplified in realization with the following (canonical) state-space representation:

The environment:

$$\dot{\bar{X}}_i = \bar{A}_i \bar{X}_i + \bar{B}_i \bar{S}, \; 1 \leq i \leq L$$

$$M = \sum_{i=1}^{L} \bar{C}_i \bar{X}_i + \bar{D} \bar{S}$$

The network:

$$\dot{X}_i = A_i X_i + B_i y, \; 1 \leq i \leq L$$

$$Z = \sum_{i=1}^{L} C_i X_i + D y$$

$$y = M-Z$$

where each $X_i$ represents a state vector of the environment of the same dimension as the source signals, and each $X_i$ represents a state of the network of the same dimension as the output signal. For simplicity, we assumed the same number, L, of the state vectors in both environment and network.

Now, using the performance index

$$I(\mathbf{y}) = -H(\mathbf{y}) + \sum_i H(y_i) \;,$$

the matrices $C_i$ and D are updated according to

$$\dot{D} = \eta D(-I + f_a(y)y^T)$$

$$\dot{C}_i = \gamma C_i(-I + f_a(y)x^T)$$

A simpler update law which was verified to work in certain cases may be satisfactory in special applications:

$$\dot{D} = \eta f_a(y)y^T$$

$$\dot{C}_i = \gamma f_a(y)x_i^T$$

Computer simulations performed demonstrated the performance of the two equations above.

It should be clear that the states may, in the simple FIR filtering, represent simple delays of the sources. while the states in the network represent delays in the fed back output signals. However, this view is a simple consideration of the delays of the signal that occur in real physical applications. The framework, therefore, is more general since it may consider arbitrary delays including those of IIR filtering and continuous-time physical effects.

Observations

Connection to Information Maximization

One can rewrite the averaged mutual information in terms of the entropy of the output vector of a nonlinear network with a weight matrix followed by an activation function nonlinear. This view would link the about analytical approach with the information-maximization approach. To see the connection, we now proceed fill lows. Using

$$(f_y(u) = \frac{f_m(u)}{|W|} \; .),$$

one can re-express the mutual information criterion as

$$I(y) = E[\ln \frac{f_M(u)}{|W|\Pi_i f_{yi}(u_i)]}$$

$$\int f_y(u) \ln \frac{f_M(u)}{|W|\Pi_i f_{yi}(u_i)} du$$

One can now view the expression

$$|W| \prod_i f_{yi}(u_i)$$

as the Jacobian of a nonlinear (activation) function applied to the output vector components. Thus i f we were to insert an activation function nonlinearity, following the linear mapping of the weight matrix, we would render the expression for

$$I(y) = \int f_y(u) \ln \frac{f_y(u)}{\Pi_i f_{yi}(u_i)} du$$

equals to

$$I(y) = E[\ln f_y(u)]$$

Note that, in this last step, we took the liberty in using the same symbol f to stand for the unknown joint probability function of the vector output of the non linear activation function.

Thus now one can state that the minimization of

$$I(y) = \int f_y(u) \ln \frac{f_y(u)}{\Pi_i f_{yi}(u_i)} du$$

is equivalent to the minimization of $I(y) = E[\ln f_y(u)]$. One observes that minimizing the quantity $I(y) = E[\ln f_y(u)]$ is, by definition, equal to the maximization of the entropy function of the output of the nonlinear activation function. Note that the nonlinear activation function used is constructed so that its derivative is necessarily equal to the marginal probability distributions. Hence this establishes the exact link between the analytical approach pursued herein with other discussions. This bypasses the generally invalid assumptions made previously which assume that

$$H(y|e)$$

does not depend on the weight matrix.

We note that the crux of the matter in the formulation is to determine an approximation to the marginal probability density functions. Such an approximation needs to rely on the statistical properties of the processed signals and justifid by analytical means.

Stochastic versus Deterministic Update

Two key points should be noted, One is that while the formulation adopts a stochastic functional, in the eventual implementation of the update laws, only deterministic functions of the output variable y are used. The second point is that the update laws of $\dot{W} = \eta[W^{-T} - f_a(y)M^T]$ or $\dot{W} = \eta[L - f_a(y)y^T]W$ are applied on line. In contrast, the application of the update laws described before are applied using a window and selecting random output samples to emulate the stochastic process in the update law.

Implementation of the architectures and update laws

A direct hardware implementation of a practical extension of the HJ network to a first-order dynamic network has been reported previously with experimental results. Direct implementations represent an avenue of effective implementation of the architectures and algorithms for the fastest execution of the recovery network.

Another paradigm includes DSP architectures. For a DSP based emulation of the signal separation algorithm families discussed here, it will be up to the tradeoffs in a particular application to identify the best processor architecture and numerical representations, e.g., floating or fixed point. To achieve a highly integrated solution (e.g., one chip) will require embedding a DSP core either from a pre-designed device or designed from standard silicon cell libraries.

The compiler front-end to the DSP assembler and linker forms a direct bridge from a high level language coded algorithm simulation environment to DSP emulation. In addition, a similar direct link exists between many computing environments and the DSP emulation environments. for example, C/C++ library and compilers for various processors.

Programmable logic can be an integral part of the related development process. A programmable DSP core (a DSP processor that is designed for integration into a custom chip) can be integrated with custom logic to differentiate a system and reduce system cost, space, and power consumption.

**Claims**

1. An acoustic signal discrimination system for discriminating a plurality of input signals *M* into a plurality of output signals *Y*, the input signals being composed of functions of a plurality of source signals that have been affected by a medium, the source signals being associated with a plurality of sources, the output signals estimating the source signals, the system comprising an architecture processor for defining and computing a plurality of parameters of a signal separation architecture, the architecture comprising a feedback state space representation establishing a relationship between the input signals and the output signals as

$$\dot{X}_i = A_i X_i + B_i Y \text{ for } 1 \le i \le L$$

$$Z = \sum_{i=1}^{L} C_i X_i + DY$$

$$Y = M - Z$$

where $X_i$ represents a state vector of the environment, *L* is the number of state vectors, $A_i$, $B_i$, $C_i$ and *D* are parameter matrices describing the environment, whereby $A_i$ and $B_i$ are state update matrices, and $C_i$ and $D$ are matrices updated according to

$$\dot{C}_i = \gamma C_i \left( - I + f_a(Y)X^T \right)$$

$$\dot{D} = \eta D \left( - I + f_a(Y)Y^T \right)$$

where $I$ is a performance index, $\gamma$ and $\eta$ are constants, $f_a(\bullet)$ is a non-linear odd function, and superscript T denotes the transpose.

2. An acoustic signal discrimination system according to claim 1 further comprising a plurality of sensors for detecting the input signals and an output processor for computing the output signals based on the signal separation method or architecture.

3. An acoustic signal discrimination system according to claim 1 or claim 2 wherein

$$f_a(y) = \frac{71}{12} y^{15} - \frac{355}{12} y^{13} + \frac{190}{3} y^{11} - \frac{4033}{24} y^9 + \frac{941}{3} y^7 + \frac{47}{8} y^5 + y^3 + y.$$

4. An acoustic signal discrimination system according to claim 1 or claim 2 wherein $f_a$ comprises a hyperbolic function.

5. An acoustic signal discrimination system according to claim 1 or claim 2 wherein $f_a$ comprises an inverse of a sigmoidal function.

6. An acoustic signal discrimination system according to any one of claims 1-5 wherein the input signals are received and stored in a device.

7. An acoustic signal discrimination system according to any one of claims 1-6 wherein the acoustic signal discrimination system also contains an update processor computing the variable parameters of the signal separation architecture.

8. An acoustic signal discrimination system according to any one of claims 1-7 wherein the acoustic signal discrimination system contains an input signal processor for computing functions of the input signals.

9. An acoustic signal discrimination system according to any one of claims 1-8 wherein the acoustic signal discrimination system contains an output signal processor for computing functions of the output signals.

10. An acoustic signal discrimination system according to claim 8 or claim 9 wherein the variable parameters of the signal separation architecture are computed based on the data from either of the input or the output signal processor, or both.

11. An acoustic signal discrimination system according to claim 2 or any one of claims 3-10 when dependent on claim 2 wherein the plurality of sensors are arranged in a sensor array having a directional response pattern.

12. An acoustic signal discrimination system according to claim 11 wherein the directional response pattern of the sensor array is capable of being modified by performing signal processing on the input signals.

13. An acoustic signal discrimination system according to any one of claims 1-12 wherein a quantity of the input signals and a quantity of the output signals are not equal.

14. An acoustic signal discrimination system according to any one of claims 1-13 wherein at least one output signal is a function of at least two source signals.

15. An acoustic signal discrimination system according to any one of claims 1-14 wherein at least two output signals are functions of a same source signal.

16. An acoustic signal discrimination system according to any one of claims 1-15 wherein the feedback state space representation is mapped at least in part onto a finite impulse response (FIR) filter.

17. An acoustic signal discrimination system according to any one of claims 1-16 wherein the state space representation is mapped at least in part onto an infinite impulse response (IIR) filter.

18. An acoustic signal discrimination system according to any one of claims 1-17 wherein the state space representation is generalized to a nonlinear time variant function.

19. A method for separating a plurality of source signals comprising:

receiving a plurality of input signals $M$;
computing a plurality of output signals $Y$, the output signals estimating the source signals, the output signals based on parameters of a signal separation architecture; and
presenting the plurality of output signals;

wherein the signal separation architecture comprises a feedback state space representation establishing a relationship between the input signals and the output signals as

$$\dot{X}_i = A_i X_i + B_i Y \text{ for } 1 \leq i \leq L$$

$$Z = \sum_{i=1}^{L} C_i X_i + DY$$

$$Y = M - Z$$

where $X_i$ represents a state vector of the environment, $L$ is the number of state vectors, $A_i$, $B_i$, $C_i$ and $D$ are parameter matrices describing the environment, whereby $A_i$ and $B_i$ are state update matrices, and $C_i$ and $D$ are matrices updated according to

$$\dot{C}_i = \gamma C_i \left( -I + f_a(Y) X^T \right)$$

$$\dot{D} = \eta D \left( -I + f_a(Y) Y^T \right)$$

where $I$ is a performance index, $\gamma$ and $\eta$ are constants, $f_a(\bullet)$ is a non-linear odd function, and superscript T denotes the transpose.

20. A method for separating a plurality of source signals according to claim 19 wherein

$$f_a(y) = \frac{71}{12} y^{15} - \frac{355}{12} y^{13} + \frac{190}{3} y^{11} - \frac{4033}{24} y^9 + \frac{941}{3} y^7 + \frac{47}{8} y^5 + y^3 + y.$$

21. A method for separating a plurality of source signals according to claim 19 wherein $f_a$ comprises a hyperbolic function.

22. A method for separating a plurality of source signals according to claim 19 wherein $f_a$ comprises an inverse of a sigmoidal function.

23. A method for separating a plurality of source signals according to any one of claims 19-22 further comprising storing the input signals.

24. A method for separating a plurality of source signals according to any one of claims 19-23 further comprising storing the output signals.

25. A method for separating a plurality of source signals according to any one of claims 19-24 further comprising computing transforms of or analysis of the input signals.

26. A method for separating a plurality of source signals according to any one of claims 19-25 further comprising computing transforms of or analysis of the output signals.

27. A method for separating a plurality of source signals according to any one of claims 19-26 wherein the architecture is altered during the execution of the method.

28. A method for separating a plurality of source signals according to any one of claims 19-27 wherein zeros or a random set of numbers is used to initialize parameters.

29. A method for separating a plurality of source signals according to any one of claims 19-28 further comprising using parameters previously computed by another method instance overlapped in time.

30. A method for separating a plurality of source signals according to any one of claims 19-29 further comprising using parameters computed by a previously terminated method instance.

**Patentansprüche**

1. Akustisches Signalunterscheidungssystem für das Unterscheiden einer Mehrzahl von Eingangssignalen M in eine Mehrzahl von Ausgangssignalen Y, wobei die Eingangssignale aus Funktionen einer Mehrzahl von Quellsignalen zusammengesetzt sind, auf die sich ein Medium ausgewirkt hat, wobei die Quellsignale mit einer Mehrzahl von Quellen verknüpft sind, wobei die Ausgangssignale die Quellsignale bewerten bzw. abschätzen, wobei das System einen Architekturprozessor aufweist für das Definieren und Berechnen einer Mehrzahl von Parametern einer Signaltrennungsarchitektur, wobei die Architektur eine Rückkopplungszustandraumdarstellung aufweist, die eine Beziehung zwischen den Eingangssignalen und den Ausgangssignalen errichtet zu

$$\dot{X}_i = A_i X_i + B_i Y \text{ für } 1 \leq i \leq L$$

$$Z = \sum_{i=1}^{L} C_i X_i + DY$$

$$Y = M - Z$$

wobei $X_i$ einen Zustandsvektor der Umgebung darstellt, L die Anzahl der Zustandsvektoren ist, $A_i$, $B_i$, $C_i$ und D Parametermatrizen sind, welche die Umgebung beschreiben, wobei $A_i$ und $B_i$ Zustandsaktualisierungsmatrizen sind und $C_i$ und D Matrizen sind, die aktualisiert werden gemäß

$$\dot{C}_i = \gamma C_i \left( -I + f_a(Y) X^T \right)$$

$$\dot{D} = \eta D \left( -I + f_a(Y) Y^T \right)$$

wobei I ein Leistungsindex ist, $\gamma$ und $\eta$ Konstanten sind, $f_a$ (•) eine nicht-lineare ungerade Funktion ist und die hochgestellte Zahl T die transponierte Matrix darstellt.

2. Akustisches Signalunterscheidungssystem nach Anspruch 1, das weiterhin eine Mehrzahl von Sensoren aufweist für das Erfassen der Eingangssignale und einen Ausgangsprozessor aufweist für das Berechnen der Ausgangssignale, basierend auf dem Signaltrennverfahren oder der Signaltrennarchitektur.

3. Akustisches Signalunterscheidungssystem nach Anspruch 1 oder Anspruch 2, in dem

$$f_a(y) = \frac{71}{12}\, y^{15} - \frac{355}{12}\, y^{13} + \frac{190}{3}\, y^{11} - \frac{4033}{24}\, y^{9} + \frac{941}{3}\, y^{7} + \frac{47}{8}\, y^{5} + y^{3} + y.$$

4. Akustisches Signalunterscheidungssystem nach Anspruch 1 oder Anspruch 2, wobei $f_a$ eine hyperbolische Funktion aufweist.

5. Akustisches Signalunterscheidungssystem nach Anspruch 1 oder Anspruch 2, wobei $f_a$ das Inverse einer S-förmigen Funktion aufweist.

6. Akustisches Signalunterscheidungssystem nach einem der Ansprüche 1 bis 5, wobei die Eingangssignale in einer Vorrichtung empfangen und gespeichert werden.

7. Akustisches Signalunterscheidungssystem nach einem der Ansprüche 2 bis 6, wobei das akustische Signalunterscheidungssystem ebenso einen Aktualisierungsprozessor enthält, der die variablen Parameter der Signaltrennarchitektur berechnet.

8. Akustisches Signalunterscheidungssystem nach einem der Ansprüche 1 bis 7, wobei das akustische Signalunterscheidungssystem einen Eingangssignalprozessor für das Berechnen von Funktionen der Eingangssignale enthält.

9. Akustisches Signalunterscheidungssystem nach einem der Ansprüche 1 bis 8, wobei das akustische Signalunterscheidungssystem einen Ausgangssignalprozessor für das Berechnen von Funktionen des Ausgangssignals enthält.

10. Akustisches Signalunterscheidungssystem nach Anspruch 8 oder Anspruch 9, wobei die variablen Parameter der Signaltrennarchitektur berechnet werden, basierend auf den Daten von entweder dem Eingangs- oder dem Ausgangssignalprozessor oder von beiden.

11. Akustisches Signalunterscheidungssystem nach Anspruch 2 oder irgendeinem der Ansprüche 3 bis 10, wenn sie von Anspruch 2 abhängig sind, wobei die Mehrzahl von Sensoren in einer Sensoranordnung mit einem direktionalen Antwortmuster angeordnet sind.

12. Akustisches Signalunterscheidungssystem nach Anspruch 11, wobei das direktionale Antwortmuster der Sensoranordnung durch das Durchführen der Signalverarbeitung auf den Eingangssignalen modifiziert werden kann.

13. Akustisches Signalunterscheidungssystem nach einem der Ansprüche 1 bis 12, wobei eine Anzahl der Eingangssignale und eine Anzahl der Ausgangssignale nicht gleich sind.

14. Akustisches Signalunterscheidungssystem nach einem der Ansprüche 1 bis 13, wobei zumindest ein Ausgangssignal eine Funktion von zumindest zwei Quellsignalen ist.

15. Akustisches Signalunterscheidungssystem nach einem der Ansprüche 2 bis 14, wobei zumindest zwei Ausgangssignale Funktionen eines gleichen Quellsignals sind.

16. Akustisches Signalunterscheidungssystem nach einem der Ansprüche 1 bis 15, wobei die Rückkopplungszustandsraumdarstellung zumindest teilweise auf einem finiten Antwortfilter (FIR) abgebildet wird.

17. Akustisches Signalunterscheidungssystem nach einem der Ansprüche 1 bis 16, wobei die Zustandsraumdarstellung zumindest teilweise auf ein infinites Impulsantwortfilter (IIR) abgebildet wird.

18. Akustisches Signalunterscheidungssystem nach einem der Ansprüche 1 bis 17, wobei die Zustandsraumdarstellung auf eine nicht-lineare zeitvariante Funktion generalisiert ist.

**19.** Verfahren für das Trennen einer Mehrzahl von Quellsignalen, das aufweist:

$$\dot{X}_i = A_i X_i + B_i Y \text{ für } 1 \leq i \leq L$$

$$Z = \sum_{i=1}^{L} C_i X_i + DY$$

$$Y = M - Z$$

Empfangen einer Mehrzahl von Eingangssignalen M,
Berechnen einer Mehrzahl von Ausgangssignalen Y, wobei die Ausgangssignale die Quellsignale abschätzen, wobei die Ausgangssignale auf Parametern einer Signaltrennarchitektur basieren, und
Repräsentieren der Mehrzahl von Ausgangssignalen,
wobei die Signaltrennarchitektur eine Rückkopplungszustandsraumdarstellung aufweist, die eine Beziehung zwischen den Eingangssignalen und den Ausgangssignalen errichtet zu:

$$\dot{C}_i = \gamma C_i \left( -I + f_a(Y) X^T \right)$$

$$\dot{D} = \eta D \left( -I + f_a(Y) Y^T \right)$$

wobei $X_i$ einen Zustandsvektor der Umgebung darstellt, L die Anzahl von Zustandsvektoren ist, $A_i$, $B_i$, $C_i$ und D Parametermatrizen sind, welche die Umgebung beschreiben, wobei $A_i$ und $B_i$ Zustandsaktualisierungsmatrizen sind und $C_i$ und D Matrizen sind, die aktualisiert werden gemäß
wobei I ein Leistungsindex ist, $\gamma$ und $\eta$ Konstanten sind, $f_a(\bullet)$ eine nicht-lineare ungerade Funktion ist und der hochgestellte Buchstabe T die transponierte Matrix darstellt.

**20.** Verfahren für das Trennen einer Mehrzahl von Quellsignalen nach Anspruch 19, wobei

$$f_a(y) = \frac{71}{12} y^{15} - \frac{355}{12} y^{13} + \frac{190}{3} y^{11} - \frac{4033}{24} y^9 + \frac{941}{3} y^7 + \frac{47}{8} y^5 + y^3 + y.$$

**21.** Verfahren für das Tennen einer Mehrzahl von Quellsignalen nach Anspruch 19, wobei $f_a$ einer hyperbolische Funktion aufweist.

**22.** Verfahren für das Trennen einer Mehrzahl von Quellsignalen nach Anspruch 19, wobei $f_a$ das Inverse einer S-förmigen Funktion aufweist.

**23.** Verfahren für das Trennen einer Mehrzahl von Quellsignalen nach einem der Ansprüche 19 bis 22, das weiterhin das Speichern der Eingangssignale aufweist.

**24.** Verfahren für das Trennen einer Mehrzahl von Quellsignalen nach einem der Ansprüche 19 bis 23, das weiterhin das Speichern der Ausgangssignale aufweist.

**25.** Verfahren für das Trennen-einer Mehrzahl von Quellsignalen nach einem-der-Ansprüche 19-bis 24, das weiterhin das Berechnen der Transformationen der Eingangssignale oder der Analyse der Eingangssignale aufweist.

**26.** Verfahren zum Tennen einer Mehrzahl von Quellsignalen nach einem der Ansprüche 19 bis 25, das weiterhin aufweist das Berechnen der Transformationen der Ausgangssignale oder der Analyse der Ausgangssignale.

**27.** Verfahren zum Trennen einer Mehrzahl von Quellsignalen nach einem der Ansprüche 19 bis 26, wobei die Architektur während der Ausführung des Verfahrens verändert wird.

**28.** Verfahren zum Trennen einer Mehrzahl von Quellsignalen nach einem der Ansprüche 19 bis 27, wobei Null oder ein Zufallssatz von Zahlen verwendet wird, um die Parameter zu intialisieren.

**29.** Verfahren zum Trennen einer Mehrzahl von Quellsignalen nach einem der Ansprüche 19 bis 28, das weiterhin die Verwendung von Parametern aufweist, die vorher durch einen anderen Verfahrensvorgang, der in der Zeit überlappt, berechnet wurden.

**30.** Verfahren zum Trennen einer Mehrzahl von Quellsignalen nach einem der Ansprüche 19 bis 29, das weiterhin aufweist die Verwendung von Parametern, die durch ein vorher beendeten Verfahrensvorgang berechnet wurden.

**Revendications**

**1.** Système de discrimination de signaux acoustiques pour discriminer une multiplicité de signaux d'entrée M en une multiplicité de signaux de sortie Y, les signaux d'entrée étant composés de fonctions d'une multiplicité de signaux de sources qui ont été affectés par un milieu, les signaux de sources étant associés à une multiplicité de sources, les signaux de sortie estimant les signaux de sources, le système comprenant un processeur d'architecture pour définir et calculer une multiplicité de paramètres d'une architecture de séparation de signaux, l'architecture comprenant une représentation d'espace d'états de rétroaction, établissant une relation entre les signaux d'entrée et les signaux de sortie sous la forme :

$$\dot{X}_i = A_i X_i + B_i Y \text{ pour } 1 \le i \le L$$

$$Z = \sum_{i=1}^{L} C_i X_i + DY$$

$$Y = M - Z$$

dans laquelle $X_i$ représente un vecteur d'état de l'environnement, L est le nombre de vecteurs d'état, $A_i$, $B_i$, $C_i$ et D sont des matrices de paramètres décrivant l'environnement, parmi lesquelles $A_i$ et $B_i$ sont des matrices d'actualisation d'état, et $C_i$ et D sont des matrices actualisées conformément à :

$$\dot{C}i = \gamma C_i(-I + f_a(Y)X^T)$$

$$\dot{D} = \eta D(-I + f_a(Y)Y^T)$$

avec les notations suivantes : I est un index de performance, $\gamma$ et $\eta$ sont des constantes, $f_a(\cdot)$ est une fonction impaire non linéaire, et l'indice supérieur T désigne la transposée.

**2.** Système de discrimination de signaux acoustiques selon la revendication 1, comprenant en outre une multiplicité de capteurs pour détecter les signaux d'entrée et un processeur de sortie pour calculer les signaux de sortie sur la base du procédé ou de l'architecture de séparation de signaux.

**3.** Système de discrimination de signaux acoustiques selon la revendication 1 ou la revendication 2, dans lequel :

$$f_a(y) =$$

$$\frac{71}{12} y^{15} - \frac{355}{12} y^{13} + \frac{190}{3} y^{11} - \frac{4033}{24} y^9 + \frac{941}{3} y^7 + \frac{47}{8} y^5 + y^3 + y.$$

**4.** Système de discrimination de signaux acoustiques selon la revendication 1 ou la revendication 2, dans lequel $f_a$ est une fonction hyperbolique.

**5.** Système de discrimination de signaux acoustiques selon la revendication 1 ou la revendication 2, dans lequel $f_a$ est une inverse d'une fonction sigmoïde.

**6.** Système de discrimination de signaux acoustiques selon l'une quelconque des revendications 1-5, dans lequel les signaux d'entrée sont reçus et stockés dans un dispositif.

**7.** Système de discrimination de signaux acoustiques selon l'une quelconque des revendications 1-6, dans lequel le système de discrimination de signaux acoustiques contient également un processeur d'actualisation calculant les paramètres variables de l'architecture de séparation de signaux.

**8.** Système de discrimination de signaux acoustiques selon l'une quelconque des revendications 1-7, dans lequel le système de discrimination de signaux acoustiques contient un processeur de signaux d'entrée pour calculer des fonctions des signaux d'entrée.

**9.** Système de discrimination de signaux acoustiques selon l'une quelconque des revendications 1-8, dans lequel le système de discrimination de signaux acoustiques contient un processeur de signaux de sortie pour calculer des fonctions des signaux de sortie.

**10.** Système de discrimination de signaux acoustiques selon la revendication 8 ou la revendication 9, dans lequel les paramètres variables de l'architecture de séparation de signaux sont calculés sur la base des données provenant du processeur de signaux d'entrée ou du processeur de signaux de sortie, ou des deux.

**11.** Système de discrimination de signaux acoustiques selon la revendication 2 ou l'une quelconque des revendications 3-10 lorsqu'elles dépendent de la revendication 2, dans lequel la multiplicité de capteurs sont organisés en un réseau de capteurs ayant un diagramme de réponse directionnel.

**12.** Système de discrimination de signaux acoustiques selon la revendication 11, dans lequel le diagramme de réponse directionnel du réseau de capteurs peut être modifié par l'accomplissement d'un traitement de signal sur les signaux d'entrée.

**13.** Système de discrimination de signaux acoustiques selon l'une quelconque des revendications 1-12, dans lequel une quantité des signaux d'entrée et une quantité des signaux de sortie ne sont pas égales.

**14.** Système de discrimination de signaux acoustiques selon l'une quelconque des revendications 1-13, dans lequel au moins un signal de sortie est une fonction d'au moins deux signaux de sources.

**15.** Système de discrimination de signaux acoustiques selon l'une quelconque des revendications 1-14, dans lequel au moins deux signaux de sortie sont des fonctions d'un même signal de source.

**16.** Système de discrimination de signaux acoustiques selon l'une quelconque des revendications 1-15, dans lequel la représentation d'espace d'états de rétroaction est appliquée au moins en partie sur un filtre à réponse impulsionnelle finie (FIR).

**17.** Système de discrimination de signaux acoustiques selon l'une quelconque des revendications 1-16, dans lequel la représentation d'espace d'états est appliquée au moins en partie sur un filtre à réponse impulsionnelle infinie (IIR).

**18.** Système de discrimination de signaux acoustiques selon l'une quelconque des revendications 1-17, dans lequel la représentation d'espace d'états est généralisée à une fonction non linéaire variant dans le temps.

**19.** Procédé pour séparer une multiplicité de signaux de sources, comprenant les étapes suivantes :

réception d'une multiplicité de signaux d'entrée M;
calcul d'une multiplicité de signaux de sortie Y, les signaux de sortie estimant les signaux de sources, les signaux de sortie étant basés sur des paramètres d'une architecture de séparation de signaux; et
présentation de la multiplicité de signaux de sortie;

dans lequel l'architecture de séparation de signaux comprend une représentation d'espace d'états de rétroaction établissant une relation entre les signaux d'entrée et les signaux de sortie sous la forme :

$$\dot{X}_i = A_i X_i + B_i Y \text{ pour } 1 \le i \le L$$

$$Z = \sum_{i=1}^{L} C_i X_i + DY$$

$$Y = M - Z$$

dans laquelle $X_i$ représente un vecteur d'état de l'environnement, L est le nombre de vecteurs d'état, $A_i$, $B_i$, $C_i$ et D sont des matrices de paramètres décrivant l'environnement, parmi lesquelles $A_i$ et $B_i$ sont des matrices d'actualisation d'état, et $C_i$ et D sont des matrices actualisées conformément à :

$$\dot{C}_i = \gamma C_i(-I + f_a(Y)X^T)$$

$$\dot{D} = \eta D(-I + f_a(Y)Y^T)$$

avec les notations suivantes : I est un index de performance, $\gamma$ et $\eta$ sont des constantes, $f_a(\bullet)$ est une fonction impaire non linéaire, et l'indice supérieur T désigne la transposée.

**20.** Procédé pour séparer une multiplicité de signaux de sources conformément à la revendication 19, dans lequel :

$$f_a(y) =$$

$$\frac{71}{12} y^{15} - \frac{355}{12} y^{13} + \frac{190}{3} y^{11} - \frac{4033}{24} y^9 + \frac{941}{3} y^7 + \frac{47}{8} y^5 + y^3 + y.$$

**21.** Procédé pour séparer une multiplicité de signaux de sources selon la revendication 19, dans lequel $f_a$ est une fonction hyperbolique.

**22.** Procédé pour séparer une multiplicité de signaux de sources selon la revendication 19, dans lequel $f_a$ est une inverse d'une fonction sigmoïde.

**23.** Procédé pour séparer une multiplicité de signaux de sources selon l'une quelconque des revendications 19-22, comprenant en outre le stockage des signaux d'entrée.

**24.** Procédé pour séparer une multiplicité de signaux de sources selon l'une quelconque des revendications 19-23, comprenant en outre le stockage des signaux de sortie.

**25.** Procédé pour séparer une multiplicité de signaux de sources selon l'une quelconque des revendications 19-24, comprenant en outre le calcul de transformées des signaux d'entrée ou l'analyse de ceux-ci.

**26.** Procédé pour séparer une multiplicité de signaux de sources selon l'une quelconque des revendications 19-25, comprenant en outre le calcul de transformées des signaux de sortie ou l'analyse de ceux-ci.

**27.** Procédé pour séparer une multiplicité de signaux de sources selon l'une quelconque des revendications 19-26, dans lequel l'architecture est modifiée pendant l'exécution du procédé.

**28.** Procédé pour séparer une multiplicité de signaux de sources selon l'une quelconque des revendications 19-27, dans lequel des zéros ou un ensemble aléatoire de nombres sont utilisés pour initialiser des paramètres.

**29.** Procédé pour séparer une multiplicité de signaux de sources selon l'une quelconque des revendications 19-28, comprenant en outre l'utilisation de paramètres calculés précédemment par une autre instance de procédé, en chevauchement temporel.

30. Procédé pour séparer une multiplicité de signaux de sources selon l'une quelconque des revendications 19-29, comprenant l'utilisation de paramètres calculés par une instance de procédé terminée précédemment.

s(t)    sources

Mixing medium/channel

m(t)    mixed signals

Signal Separation Process

u(t)    separated signals

FIGURE 1

s(t)      A      M(t)      W      U(t)

Y(t)      Γ

FIGURE 2 (a).

s(t)      A      M(t)      U(t)

D      Γ      Y(t)

FIGURE 2 (b).

FIGURE 3.

FIGURE 4 (a)

FIGURE 4 (b)

FIGURE 5 (a).

FIGURE 5 (b).

FIGURE 6. (a)

FIGURE 6. (b)

$$\dot{\bar{x}} = \overline{A}\bar{x} + \overline{B}s$$
$$M = \overline{C}\bar{x} + \overline{D}s$$

$$\mathbf{s}\,(t)$$ $$\mathbf{M}\,(t)$$

$$\dot{x} = Ax + BM$$
$$y = Cx + DM$$

$$\mathbf{y}\,(t)$$

FIGURE 7.

$$\mathbf{s}\,(t)$$

$$\dot{x} = \bar{A}\bar{x} + \bar{B}s$$
$$m = \bar{C}\bar{x} + \bar{D}s$$

$$\mathbf{m}\,(t)$$

$$+$$ $$\Sigma$$

$$\mathbf{H}$$

$$\mathbf{y}\,(t)$$

$$-$$

$$\dot{x} = Ax + By$$
$$z = Cx + Dy$$

FIGURE 8.

FIGURE 9. (a)

data stack

FIGURE 9. (b)

signal conditioning
and filtering

microphone array

MEMORY

mixture 1    A/D        D/A    separated source 1
                               to further processing

mixture 2    A/D    D        D/A    separated source 2
                    S              to further processing
             .......  S     .......
                     P

mixture M    A/D        D/A    separated source N
                               to further processing

data stack

FIGURE 10.